# EUROPÄISCHE PATENTSCHRIFT

(11) **EP 2 419 628 B1**
(45) Veröffentlichungstag und Bekanntmachung des Hinweises auf die Patenterteilung: **04.01.2017**
(21) Anmeldenummer: 10704777.1
(22) Anmeldetag: 25.01.2010
(51) Int. Cl.: F03D 7/02

(54) **BLATTWINKELVERSTELLANTRIEB FÜR EINE WINDKRAFTANLAGE**
BLADE ANGLE ADJUSTMENT DRIVE FOR A WIND POWER PLANT
MÉCANISME DE RÉGLAGE D'ANGLE DE PALE POUR UNE ÉOLIENNE

(30) Priorität: 16.04.2009 DE 102009003788
(43) Veröffentlichungstag der Anmeldung: 22.02.2012
(73) Patentinhaber: SSB Wind Systems GmbH & Co. KG, 48499 Salzbergen (DE)
(72) Erfinder: WIBBEN, Norbert, 48499 Salzbergen (DE)
(86) Internationale Anmeldenummer: PCT/EP2010/050812
(87) Internationale Veröffentlichungsnummer: WO 2010/118898

(56) Entgegenhaltungen:
- DE-A1-102006 009 127
- DE-U1-202005 012 040
- US-A1- 2008 277 938

## Beschreibung

Die Erfindung betrifft einen Blattwinkelverstellantrieb für eine Windkraftanlage, mit wenigstens einem elektrischen Umrichter, wenigstens einem mit dem Umrichter elektrisch gekoppelten Elektromotor, der durch den Umrichter gespeist wird oder werden kann, wenigstens einem mit dem Elektromotor gekoppelten Rotorblatt, welches mittels des Elektromotors um eine Rotorblattachse gedreht wird oder werden kann, und wenigstens einer den Betrieb des Umrichters überwachenden Überwachungseinheit, mittels welcher ein oder mehrere Fehler im Betrieb des Umrichters erkannt und in Abhängigkeit davon der Betrieb des Umrichters zumindest vorübergehend unterbrochen wird oder werden kann. Ferner betrifft die Erfindung ein Verfahren zum Steuern eines Umrichters eines Blattwinkelverstellantriebs einer Windkraftanlage.

Die US 2008/0277938 A1 offenbart eine Windkraftanlage mit einem mit mehreren Rotorblättern mit variablem Blattwinkel mechanisch gekoppelten Rotor, einen von dem Rotor angetriebenen Generator, einem elektrisch mit dem Generator gekoppelten Umrichter zum Steuern der an ein elektrisches Netz abgegebenen Leistung, einer Blattwinkelsteuereinheit zum Steuern des Blattwinkels der Rotorblätter, einer Störungserfassungseinheit zum Erfassen einer Störung des Netzes oder der Windkraftanlage, einer ersten Blattwinkelsteuereinheit zum Steuern des Blattwinkels der Rotorblätter bei Störungsfreiheit und einer zweiten Blattwinkelsteuereinheit zum Steuern des Blattwinkels der Rotorblätter bei einer Störung, wobei die zweite Blattwinkelsteuereinheit die Rotorgeschwindigkeit in einem betriebsbereiten Geschwindigkeitsbereich für die Windkraftanlage hält.

Die DE 20 2005 012 040 U1 offenbart eine elektrische Einrichtung zur Verstellung von Rotorblättern mit einer Konstantstromquelle mit Spannungsbegrenzung zur gleichzeitigen Speisung eines Wechselrichters und einer Zwischenkreiseinheit, wobei wahlweise ein Akkumulatorspeicher, bestehend aus einem Entkopplungsglied und einem Akkumulator, oder ein Zwischenkreiskondensator zum Einsatz kommt. Die Strom-Spannungs-Kennlinie der Konstantstromquelle ist mit Spannungsbegrenzung so eingestellt, dass die Zwischenkreiseinheit nur im Fall der Unterbrechung des Netzes oder bei kurzzeitigen hohen Lasten des Motors beansprucht wird und als Senke für aus dem Rotor der Windenergieanlage zurückgespeiste elektrische Energie fungiert.

Die DE 10 2006 009 127 A1 beschreibt eine Windenergieanlage mit einem Rotor mit Rotorblättern, deren Anstellwinkel mittels einer Pitchverstelleinrichtung änderbar ist, wobei zum Verstellen ein an einem Pitchkreis und einem Notkreis angeschlossener Stellmotor vorgesehen ist, wobei in einem Normalbetrieb die Rotorblätter mittels des Pitchkreises und in einem Notbetrieb mittels des Notkreises betätigt sind, und der Notkreis einen elektrischen Energiespeicher, eine Schalteinrichtung, Verbindungsleitungen zu dem Stellmotor und eine Schutzeinrichtung aufweist. Die Schutzeinrichtung umfasst ein Leistungsflussdetektormodul, das dazu ausgebildet ist, zu bestimmen, ob elektrische Leistung in den oder von dem Stellmotor fließt, und weiter ein Entlademodul, das dazu ausgebildet ist, bei einem Leistungsfluss von dem Stellmotor Spannung und/oder Strom in dem Notkreis zu begrenzen.

In Windkraftanlagen werden zur Regelung der Rotorblattposition Antriebe mit Umrichtern als Pitchantriebssysteme eingesetzt. Die Antriebssysteme können dabei sowohl auf Gleichstrombasis, bestehend aus Gleichstromumrichter und Gleichstrommotor (Reihenschlussmaschine, Nebenschlussmaschine oder auch Doppelschlussmaschine), als auch auf Wechselstrombasis, bestehend aus Frequenzumrichter (mit oder ohne vektororientierter Regelung) und Drehstrommaschine (Asynchronmaschine oder Synchronmaschine), ausgeführt sein. Zur Überbrückung von Spannungsschwankungen oder vorübergehenden Spannungseinbrüchen wird bei selbstgeführten Umrichtern mit Gleichspannungszwischenkreis ein Akku oder Kondensator über Dioden auf den Zwischenkreis gekoppelt. Somit kann für diese Situationen die benötigte Energie aus den Akkus genommen werden.

Um die maximale Strombelastbarkeit der Umrichter nicht zu überschreiten, wird der aktuelle Strom überwacht. Die zulässige Stromgrenze der Umrichter ist insbesondere derart gestaltet, dass für eine definierte Zeit ein dynamischer Spitzenstrom zugelassen wird, wonach auf einen Nennstrom reduziert wird, der geringer als der Spitzenstrom ist.

In den Umrichtern sind verschiedene Überwachungsfunktionen integriert, welche die Funktionsfähigkeit des Umrichters sicherstellen. Übliche Überwachungsfunktionen dienen z.B. zur Überwachung des Drehzahlistwerts des Elektromotors, zur Überwachung der Ausgangstransistoren des Umrichters auf Überlastung (Ausgangskurzschluss, Erdschluss), zur Überwachung des den Umrichter versorgenden Netzes auf einen Netzphasenausfall (Fehlermeldung nach einstellbarer Zeit), zur Überwachung der Zwischenkreisspannung des Umrichters (Zwischenkreisspannung zu hoch, zu klein oder mit zusätzlicher Vergleichsschwelle), zur Überwachung der Elektronikversorgung, zur Überwachung des Bremswiderstands auf Überlastung, zur Überwachung der Kühlkörpertemperatur, zur Überwachung der Drehzahl auf eine Überdrehzahl, zur Überwachung des Umrichters auf einen offenen Ausgang, zur Überwachung eines in dem Umrichter ablaufenden CPU-Programms, zur Überwachung der Kommunikation (nur wenn dies zur Regelung genutzt wird: serielle Schnittstelle, CAN-Bus, Optionsmodul), zur Überwachung der Motortemperatur und Motorüberlastung sowie bei Gleichstromsystemen zusätzlich zur Überwachung des Feldstroms. Diese Überwachungen können sowohl angepasst als auch zum Teil aktiviert und/oder deaktiviert werden.

Beim Einsatz von Gleichstromantrieben wird für eine Notausfahrt in Richtung einer sicheren Position (z.B. Fahnenstellung der Rotorblätter) der Motor über Schaltkontakte direkt auf einen Akku geschaltet. Zur Sicherstellung der erforderlichen Notausfahrt in Richtung sichere Position ist bei Wechselstrom somit ein Umrichter erforderlich. Dieses Konzept wird in analoger Weise vermehrt für Gleichstromantriebe eingesetzt, da somit die Notwendigkeit der Umschaltung entfällt.

Der dynamische Spitzenstrom steht in den Umrichtern eine spezifizierte Zeit zur Verfügung (abhängig von dem tatsächlichen Wert und von der Vorbelastung), wobei diese Zeit ohne jegliche Vorbelastung gültig ist. Anschließend wird auf den eingestellten Dauerstrom (Nennstrom) reduziert. Der Wert und die Zeitdauer sind fest vorgegeben. Ferner erfolgt die Überwachung des Stromes über eine sogenannte Ixt-Berechnung.

Bei entsprechender Vorbelastung und aktuellem Strombedarf kann es somit dazu kommen, dass der Umrichter nur noch den Nennstrom zulässt. Dies kann je nach Lastmoment dazu führen, dass der geforderte Drehzahlwert des betroffenen Motors nicht erreicht wird, bis hin zum Stillstand des Antriebs, was zu gefährlichen Unsymmetrien der Rotorblattpositionen führen kann.

Erkennt eine der umrichterinternen Überwachungsfunktionen einen Fehler, führt dies zur Sperre des Umrichters, was über eine übergeordnete Überwachung der Rotorblattposition zur Auslösung einer Notausfahrt führt. Bei dieser Notausfahrt ist aber der funktionsfähige Umrichter erforderlich, sodass zunächst ein Fehlerreset durchgeführt wird. Während der Notausfahrt sind die Überwachungen weiter aktiv, so dass es erneut zu einem Stillstand des Antriebs und somit zu gefährlichen Unsymmetrien der Rotorblattposition kommen kann. Der Erfindung liegt die Aufgabe zugrunde, einen Blattwinkelverstellantrieb der eingangs genannten Art derart weiterzubilden, dass die Rotorblätter bei einer Notausfahrt ihre sichere Position möglichst rasch erreichen können.

Diese Aufgabe wird erfindungsgemäß durch einen Blattwinkelverstellantrieb nach Anspruch 1 und durch ein Verfahren nach Anspruch 8 gelöst. Bevorzugte Weiterbildungen der Erfindung sind in den Unteransprüchen gegeben.

Der erfindungsgemäße Blattwinkelverstellantrieb für eine Windkraftanlage weist wenigstens einen elektrischen Umrichter, wenigstens einen mit dem Umrichter elektrisch gekoppelten Elektromotor, der durch den Umrichter gespeist wird oder werden kann, wenigstens ein mit dem Elektromotor gekoppeltes Rotorblatt, welches mittels des Elektromotors um eine Rotorblattachse gedreht wird oder werden kann, wenigstens eine den Betrieb des Umrichters überwachende Überwachungseinheit, mittels welcher ein oder mehrere Fehler im Betrieb des Umrichters erkannt und in Abhängigkeit davon der Betrieb des Umrichters vorübergehend oder zumindest vorübergehend unterbrochen wird oder werden kann, und wenigstens eine aktivierbare Zusatzeinheit auf, durch deren Aktivierung eine Unterbrechung des Betriebs des Umrichters durch die Überwachungseinheit während einer Notausfahrt vermieden wird oder werden kann.

Durch die Aktivierung der Zusatzeinheit wird ein unterbrechungsfreier Betrieb des Umrichters selbst dann ermöglicht, wenn die Überwachungseinheit einen Fehler diagnostiziert. Somit kann die sichere Position bei der Notausfahrt relativ rasch erreicht werden. Die zumindest eine Überwachungseinheit arbeitet vorzugsweise im aktivierten Zustand der Zusatzeinheit weiter, kann allerdings keine Unterbrechung des Betriebs des Umrichters mehr herbeiführen.

Unter einer Notausfahrt ist insbesondere zu verstehen, dass ein mit dem Elektromotor gekoppeltes Rotorblatt um seine Rotorblattachse in eine sichere Position gedreht wird. Bevorzugt übt der Wind in der sicheren Position lediglich geringe Kräfte auf das Rotorblatt aus. Beispielsweise ist der Anstellwinkel des Rotorblatts in der sicheren Position Null, sodass die sichere Position auch als Fahnenstellung bezeichnet wird. Bevorzugt werden alle Rotorblätter eines Rotors einer Windkraftanlage bei einer Notausfahrt in die jeweils sichere Position gestellt. Die Zusatzeinheit wird insbesondere bei einer Notausfahrt aktiviert oder ist bei oder zusammen mit einer Notausfahrt aktivierbar.

Bevorzugt sind mehrere den Betrieb des Umrichters überwachende Überwachungseinheiten vorgesehen, mittels welchen ein oder mehrere Fehler im Betrieb des Umrichters erkannt und in Abhängigkeit davon der Betrieb des Umrichters vorübergehend oder zumindest vorübergehend unterbrochen wird oder werden kann. Die Überwachungseinheiten überwachen bevorzugt die Drehzahl des Elektromotors, die Ausgangstransistoren des Umrichters auf Überlastung, das den Umrichter versorgende elektrische Netz auf einen Ausfall, die an einem Zwischenkreis des Umrichters anliegende Zwischenkreisspannung, die Versorgung der Elektronik des Umrichters mit elektrischer Energie, den Bremswiderstand auf Überlastung, die Temperatur von am Umrichter vorgesehenen Kühlkörpern, den Elektromotor auf eine Überdrehzahl, den Umrichter auf einen offenen Ausgang, ein in dem Umrichter ablaufendes Programm, die Kommunikation zwischen dem Umrichter und einer oder mehreren anderen Einheiten (z.B. der Windenergieanlagensteuerung), die Temperatur des Elektromotors und/oder eine Überlastung des Elektromotors. Bei Gleichstromsystemen kann auch der Feldstrom überwacht werden. Jede dieser Überwachungen kann durch eine der Überwachungseinheiten durchgeführt werden. Somit können durch die Überwachungseinheiten Größen und/oder Signale überwacht werden, die durch den Betrieb des Blattwinkelverstellantriebs oder Umrichters beeinflusst werden oder werden können und/oder den Betrieb des Blattwinkelverstellantriebs oder Umrichters beeinflussen oder beeinflussen können.

Bevorzugt wird durch die oder durch jede der Überwachungseinheiten ein den Betrieb des Blattwinkelverstellantriebs oder Umrichters kennzeichnendes Signal überwacht. Insbesondere ist dabei jedem der Signale ein gültiger Wert oder ein gültiger Wertebereich zugeordnet, sodass ein Fehler immer dann vorliegt, wenn eines der Signale von dem jeweils gültigen Wert abweicht oder außerhalb des jeweils gültigen Wertebereichs liegt. Bei nicht aktivierter Zusatzeinheit und bei Erfassung eines Fehlers wird oder kann die für die Überwachung des fehlerhaften Signals zuständige Überwachungseinheit eine Unterbrechung des Betriebs des Umrichters veranlassen. Durch die Aktivierung der Zusatzeinheit wird diese Unterbrechung allerdings bei einer Notausfahrt verhindert oder kann verhindert werden. Insbesondere wird oder ist durch die Aktivierung der Zusatzeinheit eine Unterbrechung des Betriebs des Umrichters durch die Überwachungseinheiten während einer Notausfahrt vermieden bzw. vermeidbar.

Bevorzugt wird durch eine Stromüberwachungseinheit der von dem Umrichter an den Elektromotor abgegebene elektrische Ausgangsstrom überwacht und in Abhängigkeit davon die Belastung des Umrichters bestimmt. Ferner wird vorzugsweise durch wenigstens eine Strombegrenzungseinheit in einem überlasteten Zustand des Umrichters der maximal mögliche Ausgangsstrom auf einen Nennstrom reduziert, der kleiner als ein Spitzenstrom ist, den der Umrichter in einem nicht überlasteten Zustand als maximal möglichen Ausgangsstrom zur Verfügung stellt oder stellen kann. Bevorzugt erfolgt die Reduzierung des Ausgangsstroms auf den Nennstrom durch die Strombegrenzungseinheit nur bei nicht aktivierter Zusatzeinheit. Insbesondere kann durch die Aktivierung der Zusatzeinheit die Reduzierung des Ausgangsstroms auf den Nennstrom durch die Strombegrenzungseinheit vermieden werden. Bevorzugt wird durch die Aktivierung der Zusatzeinheit als maximal möglicher Ausgangsstrom der Spitzenstrom während einer Notausfahrt dauerhaft zur Verfügung gestellt, und zwar unabhängig von der Belastung des Umrichters zum Zeitpunkt der Aktivierung. Somit können eine verringerte Drehzahl und ein Stillstand des Elektromotors weitgehend vermieden werden, sodass eine rasche Notausfahrt möglich ist. Gemäß einer Ausgestaltung der Erfindung ist die Stromüberwachungseinheit die oder eine der Überwachungseinheiten. Die Stromüberwachungseinheit bildet bevorzugt eine umrichterinterne Einheit.

Der Spitzenstrom ist insbesondere größer als der Nennstrom. Vorzugsweise beträgt der Spitzenstrom das eineinhalbfache oder/bis zweifache des Nennstroms.

Bevorzugt wird mittels einer Drehzahlüberwachungseinheit ein die Drehzahl des Elektromotors repräsentierender Drehzahlistwert überwacht, zu dessen Erfassung insbesondere ein Drehzahlsensor vorgesehen ist. Vorzugsweise wird die Drehzahl des Elektromotors mittels wenigstens eines Drehzahlreglers unter Berücksichtigung des Drehzahlistwerts geregelt. Der Drehzahlistwert bildet somit ein den Betrieb des Blattwinkelverstellantriebs kennzeichnendes Signal, bei dessen Verlust, z.B. aufgrund eines defekten Drehzahlsensors, bevorzugt eine Unterbrechung des Betriebs des Umrichters durch die Drehzahlüberwachungseinheit eingeleitet wird. Der Verlust des Drehzahlistwerts stellt somit einen der Fehler dar. Bevorzugt erfolgt die Unterbrechung des Betriebs des Umrichters durch die Drehzahlüberwachungseinheit nur bei nicht aktivierter Zusatzeinheit. Insbesondere kann somit durch die Aktivierung der Zusatzeinheit die Unterbrechung des Betriebs des Umrichters durch die Drehzahlüberwachungseinheit vermieden werden. Ferner wird im aktivierten Zustand der Zusatzeinheit der Drehzahlregler bei Verlust des Drehzahlistwerts bevorzugt in eine steuernde Betriebsart (Open-Loop-Betrieb) überführt, so dass die Drehzahl des Elektromotors während einer Notausfahrt gesteuert wird oder werden kann. Die Überführung in den Open-Loop-Betrieb erfolgt vorzugsweise durch die Drehzahlüberwachungseinheit. Gemäß einer Ausgestaltung der Erfindung ist die Drehzahlüberwachungseinheit die oder eine der Überwachungseinheiten. Die Drehzahlüberwachungseinheit bildet vorzugsweise eine umrichterinterne Einheit.

Bevorzugt ist mit dem Elektromotor das wenigstens eine Rotorblatt mechanisch gekoppelt, welches mittels des Elektromotors um die Rotorblattachse gedreht wird oder werden kann. Bei Durchführung einer Notausfahrt wird das Rotorblatt mittels des Elektromotors um die Rotorblattachse in die sichere Position gedreht.

Gemäß einer Weiterbildung der Erfindung wird mittels einer Schnittstellenüberwachungseinheit eine Schnittstelle des Umrichters überwacht, mittels welcher der Umrichter mit einer Steuerung elektrisch verbunden ist, die bevorzugt eine umrichterexterne Steuerung ist. Bei fehlender und/oder fehlerhafter Verbindung zwischen dem Umrichter und der Steuerung wird bevorzugt eine Unterbrechung des Betriebs des Umrichters eingeleitet. Die fehlende und/oder fehlerhafte Verbindung zwischen dem Umrichter und der Steuerung stellt somit einen der Fehler dar. Bevorzugt erfolgt die Unterbrechung des Betriebs des Umrichters durch die Schnittstellenüberwachungseinheit nur bei nicht aktivierter Zusatzeinheit. Insbesondere kann somit durch die Aktivierung der Zusatzeinheit die Unterbrechung des Betriebs des Umrichters durch die Schnittstellenüberwachungseinheit vermieden werden. Bei aktivierter Zusatzeinheit und bei fehlender und/oder fehlerhafter Verbindung zwischen dem Umrichter und der Steuerung wird der Umrichter insbesondere zur Durchführung einer Notausfahrt angesteuert, sodass das Rotorblatt in die sichere Position gedreht wird oder werden kann. Hierzu kann durch die Schnittstellenüberwachungseinheit bevorzugt ein Notausfahrtaktivierungssignal erzeugt und einem Notausfahrtaktivierungseingang des Umrichters zugeführt werden, der daraufhin, d.h. in Antwort auf das Notausfahrtaktivierungssignal, eine Notausfahrt durchführt oder durchführen kann und das Rotorblatt in die sichere Position dreht oder drehen kann. Eine Unterbrechung des Betriebs des Umrichters wird vorzugsweise nicht eingeleitet. Gemäß einer Ausgestaltung der Erfindung ist die Schnittstellenüberwachungseinheit die oder eine der Überwachungseinheiten. Die Schnittstellenüberwachungseinheit ist vorzugsweise eine umrichterinterne Einheit, kann aber auch als umrichterexterne Einheit ausgebildet sein. Im letzteren Fall ist die Schnittstellenüberwachungseinheit bevorzugt in die Steuerung integriert. Der Notausfahrtaktivierungseingang des Umrichters ist insbesondere von außen zur Durchführung einer Notausfahrt ansteuerbar. Beispielsweise ist der Notausfahrtaktivierungseingang des Umrichters durch die Steuerung ansteuerbar. Bei aktivierter Zusatzeinheit und bei einem Fehler in der Verbindung zwischen dem Umrichter und der Steuerung ist der Notausfahrtaktivierungseingang des Umrichters bevorzugt durch die Schnittstellenüberwachungseinheit ansteuerbar oder wird durch diese angesteuert, insbesondere zur Durchführung der Notausfahrt.

Die Überwachung der Verbindung zwischen dem Umrichter und der Steuerung kann z.B. dadurch erfolgen, dass ein Prüfsignal zwischen dem Umrichter und der Steuerung übertragen wird. Bei Verlust des Prüfsignals gilt die Verbindung als fehlerhaft. Bei einer umrichterinternen Schnittstellenüberwachungseinheit kann das Prüfsignal z.B. von der Steuerung erzeugt und über die Schnittstelle dem Umrichter zugeführt werden, in welchem die Schnittstellenüberwachungseinheit das einkommende Prüfsignal überwacht. Die Steuerung ist z.B. die Steuerung der Windkraftanlage.

Der Umrichter weist bevorzugt einen Zwischenkreis auf, in den insbesondere ein elektrischer Kondensator geschaltet ist. Der Zwischenkreis ist vorzugsweise zwischen zwei Stromrichter des Umrichters, insbesondere zwischen einen Gleichrichter und einen Gleichstromsteller oder Wechselrichter des Umrichters geschaltet, wobei der Gleichrichter insbesondere einen Eingang und der Gleichstromsteller oder Wechselrichter insbesondere einen Ausgang des Umrichters bildet oder aufweist. Ist der Elektromotor ein Wechselstrommotor, so wird ausgangsseitig bevorzugt ein Wechselrichter eingesetzt. Handelt es sich bei dem Elektromotor hingegen um einen Gleichstrommotor, so wird ausgangsseitig bevorzugt ein Gleichstromsteller eingesetzt. Der Zwischenkreis ist insbesondere ein Gleichspannungszwischenkreis.

Bevorzugt wird mittels einer Zwischenkreisspannungsüberwachungseinheit die Zwischenkreisspannung des Umrichters überwacht. Liegt die Zwischenkreisspannung außerhalb eines zulässigen Bereichs, wird bevorzugt eine Unterbrechung des Betriebs des Umrichters eingeleitet. Die außerhalb des zulässigen Bereichs liegende Zwischenkreisspannung stellt somit einen der Fehler dar. Bevorzugt erfolgt die Unterbrechung des Betriebs des Umrichters durch die Zwischenkreisspannungsüberwachungseinheit nur bei nicht aktivierter Zusatzeinheit. Insbesondere kann somit durch die Aktivierung der Zusatzeinheit die Unterbrechung des Betriebs des Umrichters durch die Zwischenkreisspannungsüberwachungseinheit vermieden werden. Ferner wird bevorzugt bei aktivierter Zusatzeinheit die Zwischenkreisspannung während der Notausfahrt durch einen Spannungsregler geregelt und somit innerhalb zulässiger Grenzen gehalten. Dies gilt bevorzugt auch im generatorischen Betrieb des Elektromotors, z.B. wenn dieser zu schnell dreht. Gemäß einer Ausgestaltung der Erfindung ist die Zwischenkreisspannungsüberwachungseinheit die oder eine der Überwachungseinheiten. Die Zwischenkreisspannungsüberwachungseinheit bildet vorzugsweise eine umrichterinterne Einheit.

Der Umrichter umfasst bevorzugt einen Digitalrechner. Gemäß einer Ausgestaltung der Erfindung ist jede der Einheiten, insbesondere jede der Überwachungseinheiten und/oder die wenigstens eine Zusatzeinheit ganz oder teilweise durch den oder einen Digitalrechner gebildet. Alternativ oder ergänzend ist eine analoge Ausbildung einer oder mehrerer der Einheiten möglich.

Die Erfindung kann in eine Windkraftanlage mit einer Halterung verwendet werden, an der ein durch Wind antreibbarer oder angetriebener Rotor um eine Rotorachse drehbar gelagert ist, der eine Rotornabe und mehrere Rotorblätter aufweist, die jeweils um eine Rotorblattachse drehbar an der Rotornabe gelagert sind, und einem Blattwinkelverstellsystem, welches je Rotorblatt einen erfindungsgemäßen Blattwinkelverstellantrieb aufweist, mittels welchem das jeweilige Rotorblatt um seine Rotorblattachse drehbar ist. Dabei ist jedes Rotorblatt bevorzugt mit dem Elektromotor des jeweiligen Blattwinkelverstellantriebs gekoppelt, insbesondere mechanisch gekoppelt. Jeder der Blattwinkelverstellantriebe kann gemäß allen in diesem Zusammenhang beschriebenen Ausgestaltungen weitergebildet sein.

Die Anzahl der Rotorblätter beträgt vorzugsweise wenigstens zwei oder wenigstens drei. Insbesondere beträgt die Anzahl der Rotorblätter drei. Jede der Rotorblattachsen verläuft insbesondere quer oder schräg zur Rotorachse.

Die Erfindung betrifft ferner ein Verfahren zum Steuern eines Umrichters eines Blattwinkelverstellantriebs einer Windkraftanlage, wobei wenigstens ein mit dem Umrichter elektrisch gekoppelter Elektromotor durch den Umrichter gespeist wird, wobei ein Rotorblatt mittels des Elektromotors um eine Rotorblattachse gedreht wird, wobei der Betrieb des Umrichters auf Fehler überwacht und im Falle eines Fehlers vorübergehend oder zumindest vorübergehend unterbrochen wird, und wobei durch die Aktivierung einer Zusatzfunktion des Umrichters eine Unterbrechung des Betriebs des Umrichters im Fehlerfall während einer Notausfahrt vermieden wird. Die Unterbrechung des Betriebs des Umrichters im Fehlerfall erfolgt insbesondere nur bei fehlender Aktivierung. Bevorzugt erfolgt die Überwachung des Betriebs des Umrichters auf Fehler auch während der Aktivierung. Allerdings führt in diesem Fall ein Fehler insbesondere nicht zu einer Unterbrechung des Betriebs des Umrichters. Vorzugsweise werden auftretende Fehler aber protokolliert.

Das erfindungsgemäße Verfahren wird bevorzugt unter Verwendung des erfindungsgemäßen Blattwinkelverstellantriebs durchgeführt, sodass das Verfahren gemäß allen in diesem Zusammenhang beschriebenen Ausgestaltungen weitergebildet sein kann.

Bevorzugt wird der von dem Umrichter an den Elektromotor abgegebene elektrische Ausgangsstrom überwacht und in Abhängigkeit davon die Belastung des Umrichters bestimmt. Insbesondere wird in einem überlasteten Zustand des Umrichters der maximal mögliche Ausgangsstrom auf einen Nennstrom reduziert, der kleiner als ein Spitzenstrom ist, den der Umrichter in einem nicht überlasteten Zustand als maximal möglichen Ausgangsstrom zur Verfügung stellt. Bevorzugt erfolgt die Reduzierung des Ausgangsstroms auf den Nennstrom nur bei fehlender Aktivierung. Insbesondere wird durch die Aktivierung die Reduzierung des Ausgangsstroms auf den Nennstrom vermieden. Bevorzugt wird durch die Aktivierung als maximal möglicher Ausgangsstrom der Spitzenstrom während einer Notausfahrt dauerhaft zur Verfügung gestellt, und zwar unabhängig von der Belastung des Umrichters zum Zeitpunkt der Aktivierung.

Das Merkmal, dass als maximal möglicher Ausgangsstrom der Spitzenstrom zur Verfügung gestellt wird, muss nicht zwangsläufig zur Folge habe, dass als Ausgangsstrom auch tatsächlich der Spitzenstrom fließt. Allerdings ist dies möglich.

Gemäß einer Weiterbildung der Erfindung wird ein die Drehzahl des Elektromotors repräsentierender Drehzahlistwert überwacht und die Drehzahl des Elektromotors unter Berücksichtigung des Drehzahlistwerts geregelt. Bei Verlust des Drehzahlistwerts ist eine Regelung allerdings nicht mehr möglich, sodass eine Unterbrechung des Betriebs des Umrichters eingeleitet wird. Der Verlust des Drehzahlistwerts stellt somit einen Fehler dar. Bevorzugt erfolgt die Unterbrechung des Betriebs des Umrichters nur bei fehlender Aktivierung. Insbesondere wird durch die Aktivierung die Unterbrechung des Betriebs des Umrichters vermieden, vorzugsweise dadurch, dass die Drehzahl des Elektromotors bei Verlust des Drehzahlistwerts gesteuert wird. Dies erfolgt vorzugsweise während einer Notausfahrt.

Bei einer Notausfahrt wird das Rotorblatt insbesondere um die Rotorblattachse in die sichere Position gedreht.

Gemäß einer Ausgestaltung der Erfindung wird eine elektrische Verbindung zwischen dem Umrichter und einer Steuerung überwacht. Bei einer fehlenden und/oder fehlerhaften Verbindung zwischen dem Umrichter und der Steuerung wird eine Unterbrechung des Betriebs des Umrichters eingeleitet. Die fehlende und/oder fehlerhafte Verbindung zwischen dem Umrichter und der Steuerung stellt somit einen Fehler dar. Bevorzugt erfolgt die Unterbrechung des Betriebs des Umrichters nur bei fehlender Aktivierung. Insbesondere wird durch die Aktivierung die Unterbrechung des Betriebs des Umrichters vermieden. Bevorzugt wird durch die Aktivierung bei einer fehlenden und/oder fehlerhaften Verbindung zwischen dem Umrichter und der Steuerung der Umrichter zur Durchführung einer Notausfahrt angesteuert, sodass das Rotorblatt in die sichere Position gedreht wird. Hierzu wird insbesondere ein Notausfahrtaktivierungssignal erzeugt und einem Notausfahrtaktivierungseingang des Umrichters zugeführt. Daraufhin, d.h. in Antwort auf das Notausfahrtaktivierungssignal, wird die Notausfahrt durchgeführt und das Rotorblatt in die sichere Position gedreht.

Bevorzugt weist der Umrichter einen Zwischenkreis auf, dessen Spannung während der Notausfahrt überwacht wird. Liegt die Zwischenkreisspannung außerhalb eines zulässigen Bereichs, wird eine Unterbrechung des Betriebs des Umrichters eingeleitet. Die außerhalb des zulässigen Bereichs liegende Zwischenkreisspannung stellt somit einen Fehler dar. Bevorzugt erfolgt die Unterbrechung des Betriebs des Umrichters nur bei fehlender Aktivierung. Insbesondere wird durch die Aktivierung die Unterbrechung des Betriebs des Umrichters vermieden. Bevorzugt wird durch die Aktivierung die Zwischenkreisspannung während einer Notausfahrt geregelt und dadurch innerhalb zulässiger Grenzen gehalten. Der Zwischenkreis ist bevorzugt ein Gleichspannungszwischenkreis und insbesondere zwischen einen eingangsseitigen Gleichrichter und einen ausgangsseitigen Gleichstromsteller oder Wechselrichter des Umrichters geschaltet. Bevorzugt umfasst der Zwischenkreis einen Zwischenkreiskondensator.

Die Zusatzfunktion kann aktiviert werden. Bevorzugt kann die Zusatzfunktion auch deaktiviert werden. Gemäß einer Ausgestaltung der Erfindung wird die Zusatzfunktion durch die Zusatzeinheit bereitgestellt und/oder realisiert, die z.B. als elektrische Schaltung und/oder als Programm (Software) realisiert ist. Die Aktivierung erfolgt bevorzugt durch ein Aktivierungssignal, welches insbesondere der Zusatzeinheit zugeführt wird, vorzugsweise von der oder einer umrichterinternen und/oder umrichterexternen Steuerung, wie z.B. die Windenergieanlagensteuerung. Die Zusatzeinheit kann durch das Aktivierungssignal aktiviert und somit in einen aktivierten Zustand versetzt werden. Vorzugsweise bildet die Zusatzeinheit eine umrichterinterne Einheit und ist insbesondere ganz oder teilweise durch den Digitalrechner gebildet.

Erfindungsgemäß wird somit eine Zusatzfunktion (Zusatzeinheit) in den Umrichter integriert, die bei Aktivierung eine Notausfahrt ermöglicht, und zwar ohne dass die internen Überwachungsfunktionen des Umrichters dies unterbrechen können. Bevorzugt wird zusätzlich die Stromgrenze für den Ausgangsstrom ohne zeitliche Begrenzung auf den Wert des Spitzenstroms gesetzt, sodass der Elektromotor das Spitzenmoment aufbringen kann. Gemäß einer Weiterbildung wird bei Verlust des Drehzahlistwerts der üblicherweise daraus resultierende Antriebsstillstand durch selbsttätige, interne Umschaltung auf einen Open-Loop-Betrieb vermieden. Gemäß einer Ausgestaltung der Erfindung wird bei Steuerung des Umrichters über eine Busschnittstelle die Schnittstelle überwacht und bei fehlender Verbindung eine Meldung zur externen Ansteuerung einer Notausfahrt generiert.

Vorzugsweise wird zusätzlich während der Notausfahrt die Zwischenkreisspannung derart geregelt, dass zulässige Grenzen selbst dann eingehalten werden, wenn ein generatorischer Betrieb des Elektromotors auftritt, ohne dass eine Abschaltung den Antrieb stillsetzt und ohne dass dies zu einer Zerstörung des Umrichters führt.

Die aktivierbare Zusatzfunktion wird insbesondere in Notsituationen aktiviert, so dass eine Gefährdung der Windkraftanlage vermieden werden kann. Da durch die Aktivierung der Zusatzfunktion (Zusatzeinheit) eine Beschädigung des Umrichters auftreten kann, wird die Aktivierung der Zusatzfunktion vorzugsweise registriert, was z.B. in einem umrichterinternen Logbuch erfolgen kann, sodass Aktivierungen der Zusatzfunktion zurückverfolgt werden können.

Durch das dauerhafte Bereitstellen des Spitzenstroms im aktivierten Zustand wird zusätzlich erreicht, dass der Elektromotor trotz Vorbelastung des Umrichters ausreichend Drehmoment zur Überwindung von möglichen Schwergängigkeiten aufbringen kann. Somit ist ein Stillstand des Antriebs weitgehend vermeidbar. Ferner kann ein bereits blockierter Antrieb wieder in Gang gesetzt werden, wenn wegen der Bereitstellung des Spitzenstroms durch den Elektromotor ein Drehmoment aufgebracht werden kann, das größer als das Losbrechmoment der bestehenden Blockade ist.

Durch das Unterdrücken von Unterbrechungen des Betriebs des Umrichters im Fehlerfall und durch die Integration zusätzlicher Funktionen, wie z.B. die Umschaltung auf den Open-Loop-Betrieb sowie die Regelung der Zwischenkreisspannung, wird erreicht, dass der erfindungsgemäße Antrieb mit großer Verfügbarkeit nutzbar ist, sofern die auftretenden Fehler die Funktion des Umrichters noch ermöglichen.

Die Erfindung wird nachfolgend anhand einer bevorzugten Ausführungsform unter Bezugnahme auf die Zeichnung beschrieben. In der Zeichnung zeigen:
- Fig. 1: eine schematische Darstellung einer Windkraftanlage,
- Fig. 2: ein schematisches Blockschaltbild eines Blattwinkelverstellantriebs,
- Fig. 3: ein schematisches Blockschaltbild für eine Stromüberwachung,
- Fig. 4: ein schematisches Blockschaltbild für eine Drehzahlüberwachung,
- Fig. 5: eine schematische Draufsicht auf den Rotor der Windenergieanlage,
- Fig. 6: einen schematischen Verlauf des Belastungssignals,
- Fig. 7: einen schematischen Verlauf des Motorstroms,
- Fig. 8: eine schematische Schnittansicht eines Rotorblatts, und
- Fig. 9: eine schematische Darstellung mehrerer Einheiten.

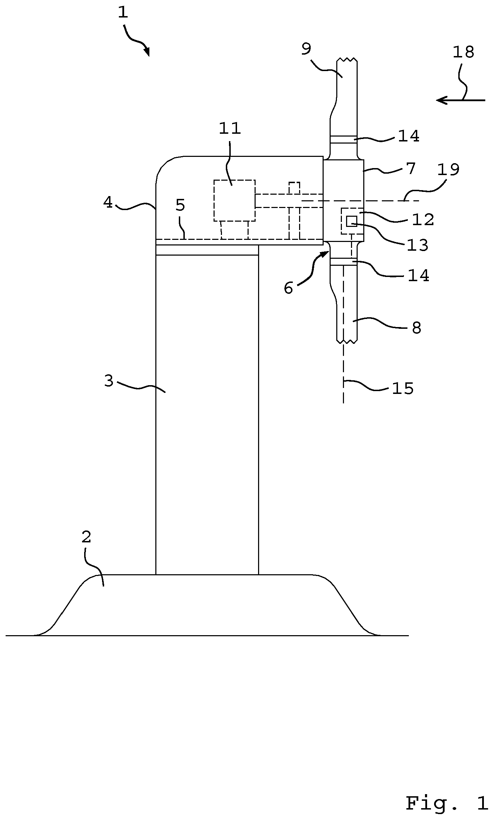

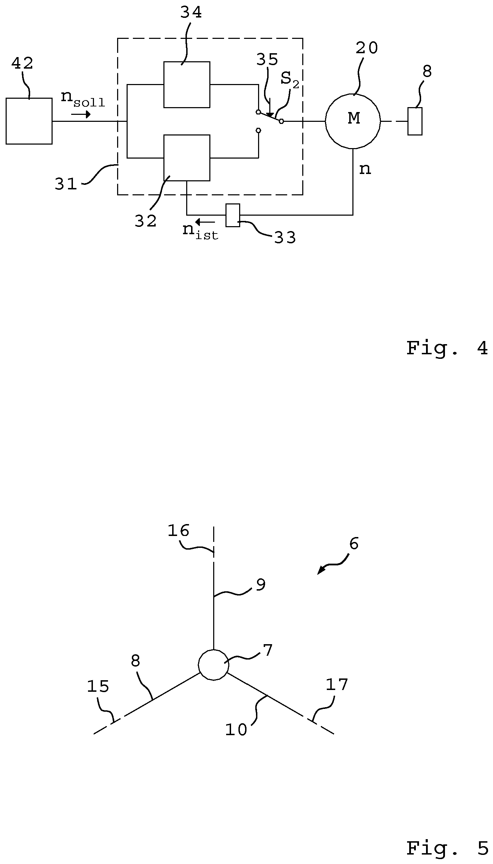

Aus Fig. 1 ist eine schematische Ansicht einer Windkraftanlage 1 ersichtlich, die einen auf einem Fundament 2 aufstehenden Turm 3 umfasst, an dessen dem Fundament 2 abgewandten Ende ein Maschinenhaus 4 angeordnet ist. Das Maschinenhaus 4 weist eine Halterung (Träger) 5 auf, an der ein Rotor 6 drehbar gelagert ist, der eine Rotornabe 7 und mehrere mit dieser verbundene Rotorblätter 8, 9 und 10 umfasst (siehe auch Fig. 5). Der Rotor 6 ist mechanisch mit einem elektrischen Generator 11 gekoppelt, der in dem Maschinenhaus 4 angeordnet und an dem Träger 5 befestigt ist.

In dem Rotor 6 ist ein Blattwinkelverstellsystem 12 angeordnet, welches Umrichter 13 umfassende Blattwinkelverstellantriebe 14 gemäß einer Ausführungsform der Erfindung aufweist, mittels welchen die Rotorblätter 8, 9 und 10 um ihre jeweilige Längsachse (Rotorblattachse) 15, 16 bzw. 17 relativ zur Rotornabe 7 gedreht werden können (siehe auch Fig. 5). Jedem der Rotorblätter ist bevorzugt einer der Blattwinkelverstellantriebe 14 zugeordnet. Der Rotor 6 wird durch Windkraft 18 um eine Rotorachse 19 gedreht.

Fig. 5 zeigt eine schematische Draufsicht auf den Rotor 6, sodass die drei Rotorblätter 8, 9 und 10 ersichtlich sind.

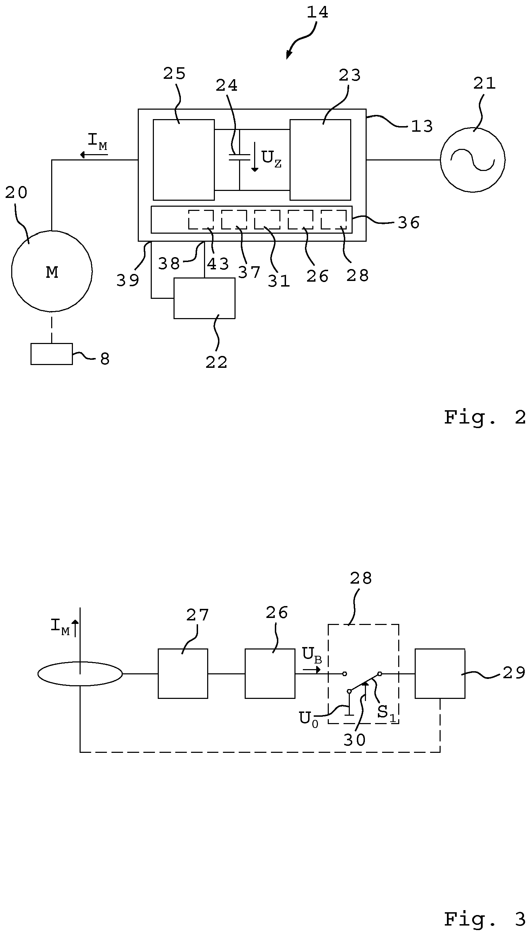

In Fig. 2 ist ein schematisches Blockschaltbild eines der Blattwinkelverstellantriebe 14 des Rotorblattverstellsystems 12 dargestellt, wobei ein hier als Gleichstrommotor ausgebildeter Elektromotor 20 elektrisch mit einem der Umrichter 13 gekoppelt ist, der mit einem elektrischen Versorgungsnetz 21 verbunden ist und aus diesem gespeist wird. Ferner ist der Umrichter 13 mit einer Steuerung 22 verbunden, mittels welcher der Umrichter 13 gesteuert wird. Der Umrichter 13 umfasst einen Gleichrichter 23, einen Zwischenkreis mit Kondensator 24 und einen Gleichstromsteller 25. Der Motor 20 ist mechanisch mit dem Rotorblatt 8 gekoppelt, welches mittels des Motors 20 um die Rotorblattachse 15 drehbar ist.

Wie aus Fig. 3 ersichtlich, umfasst der Umrichter 13 eine Stromüberwachungseinheit 26, die mittels eines Strommessers 27 den Motorstrom (Ausgangsstrom) IM erfasst und in Abhängigkeit davon ein die Belastung des Umrichters 13 charakterisierendes Belastungssignal UB erzeugt, welches unter Zwischenschaltung einer Zusatzeinheit 28 einer Strombegrenzungseinheit 29 zugeführt wird oder werden kann. Die Strombegrenzungseinheit 29 begrenzt den Motorstrom IM auf einen Spitzenstrom IS, sofern das Belastungssignal UB unterhalb eines Schwellenwerts US liegt. Erreicht oder übersteigt das Belastungssignal UB den Schwellenwert US, so wird der Motorstrom IM mittels der Strombegrenzungseinheit 29 auf einen Nennstrom IN reduziert, der kleiner als der Spitzenstrom IS ist. Vorzugsweise beträgt der Nennstrom IN den halben Spitzenstrom IS.

Die Zusatzeinheit 28 ist in Fig. 3 lediglich teilweise dargestellt und umfasst einen Schalter S1, der mittels eines Schaltsignals 30 umgeschaltet werden kann. Der Schalter S1 ist z.B. durch einen Transistor oder durch ein Relais gebildet. Im dargestellten Zustand, der einem aktivierten Zustand der Zusatzeinheit 28 entspricht, wird nicht das Belastungssignal UB auf die Strombegrenzungseinheit 29 geschaltet sondern ein Signal U0, welches einen unbelasteten Zustand des Umrichters 13 kennzeichnet und somit den Schwellenwert US weder erreicht noch überschreitet. Mittels des Schaltsignals 30 lässt sich der Schalter S1 aber in eine zweite Position umschalten, in welcher der Strombegrenzungseinheit 29 das Belastungssignal UB zugeführt wird, was in einem deaktivierten Zustand der Zusatzeinheit 28 der Fall ist. Für die Strombegrenzungseinheit 29 tritt im aktivierten Zustand der Zusatzeinheit 28 nie ein überlasteter Zustand des Umrichters 13 ein, sodass stets der Spitzenstrom IS als Ausgangsstrom IM zur Verfügung gestellt wird.

Aus Fig. 4 ist ein schematisches Blockschaltbild für eine Drehzahlüberwachung ersichtlich, umfassend einen Drehzahlregler 31 zur Regelung der Drehzahl n des Elektromotors 20, die mittels eines Drehzahlsensors 33 erfasst und dem Drehzahlregler 31 in Form eines Drehzahlistwerts nist zugeführt wird. Ferner wird dem Drehzahlregler 31 von einem Sollwertgeber 42 ein Drehzahlsollwert nsoll zugeführt. Für den Fall, dass der Drehzahlistwert nist nicht zur Verfügung steht, kann auf einen gesteuerten Betrieb des Drehzahlreglers 31 umgeschaltet werden, der dazu eine Drehzahlsteuerungseinheit 34 und einen Schalter S2 umfasst, der mittels eines Schaltsignals 35 betätigt werden kann. Der Schalter S2 ist z.B. durch einen Transistor oder durch ein Relais gebildet. Eine den eigentlichen Regler bildende Drehzahlregelungseinheit 32 ist ebenfalls schematisch dargestellt. In der gezeigten Stellung des Schalters S2 ist der Drehzahlregler 31 in den gesteuerten Betrieb geschaltet, der ohne Drehzahlistwert möglich ist. Durch Umschalten des Schalters S2 mittels des Schaltsignals 35 wird der Motor 20 allerdings in einen geregelten Betrieb umgeschaltet, der ohne Drehzahlistwert nicht möglich ist.

Die Einheiten 26, 28 und 31 sind in den Fig. 3 und 4 lediglich schematisch dargestellt und werden mittels eines in den Umrichter 13 integrierten Digitalrechners 36 auf numerischem Wege realisiert. Entsprechendes gilt für einen Spannungsregler 37, mittels welchem im aktivierten Zustand der Zusatzeinheit 28 die Zwischenkreisspannung UZ geregelt und somit innerhalb vorgegebener Grenzen gehalten werden kann. Ferner wird eine Schnittstelle 38 des Umrichters 13 überwacht, mittels welcher die Steuerung 22 mit dem Umrichter 13 verbunden ist. Bei einer fehlerhaften Verbindung der Steuerung 22 mit dem Umrichter 13 über die Schnittstelle 38 wird über einen Notausfahrtaktivierungseingang 39 des Umrichters 13 eine Notausfahrt eingeleitet, indem eine durch den Rechner 36 realisierte Schnittstellenüberwachungseinheit 43 oder die Steuerung 22 ein geeignetes Notausfahrtaktivierungssignal erzeugt und dem Notausfahrtaktivierungseingang 39 zuführt.

Bei einer Notausfahrt wird vorzugsweise stets die Zusatzeinheit 28 aktiviert, und zwar unabhängig davon, ob die Notausfahrt extern, z.B. über die Schnittstelle 38 oder über den Eingang 39, oder intern, z.B. durch eine der Einheiten oder den Digitalrechner 36, ausgelöst wird.

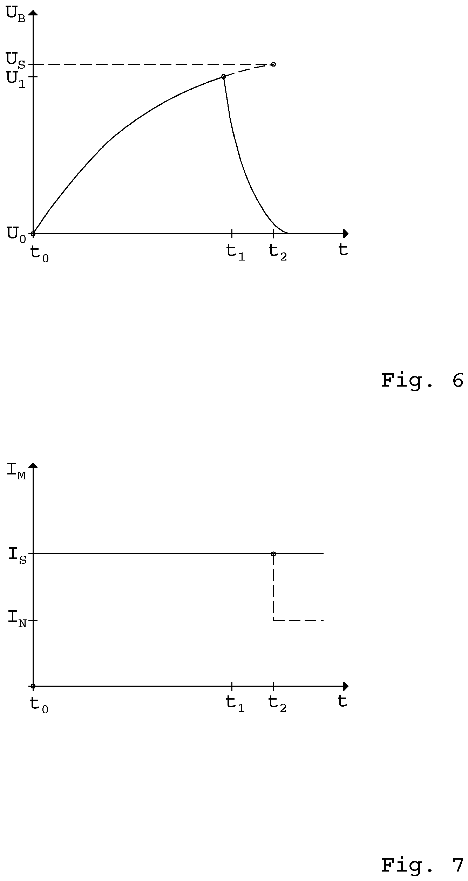

Aus Fig. 6 ist schematisch ein Verlauf des Belastungssignals UB über der Zeit t aufgetragen, wobei U0 den unbelasteten Zustand des Umrichters 13 zum Zeitpunkt t0 kennzeichnet. Als Motorstrom IM fließt hier dauerhaft der maximal zulässige Spitzenstrom IS, so dass das Belastungssignal UB stetig ansteigt. Zu einem Zeitpunkt t1 wird der Schalter S1 geschlossen und das Belastungssignal UB wieder auf den unbelasteten Zustand U0 zurückgesetzt. Der Spitzenstrom IS fließt somit weiter, was aus Fig. 7 ersichtlich ist, in der ein Verlauf des Motorstroms IM über der Zeit t aufgetragen ist. Zum Schaltzeitpunkt t1 weist die Spannung UB einen Wert U1 auf, der einen belasteten Zustand des Umrichters 13 kennzeichnet. Der Wert U1 liegt zwischen dem Wert U0 für den unbelasteten Zustand und dem Wert US, der den überlasteten Zustand des Umrichters 13 kennzeichnet. In Fig. 6 ist die den überlasteten Zustand des Umrichters 13 kennzeichnende Schwellenspannung US dargestellt.

Nachfolgend wird davon ausgegangen, dass der Schalter S1 zum Zeitpunkt t1 nicht geschlossen wird, so dass bei weiterhin fließendem Spitzenstrom IS die Spannung UB zu einem Zeitpunkt t2 den Schwellenwert US erreicht (in Fig. 6 gestrichelt dargestellt), was eine sofortige Reduzierung des Ausgangsstroms IM auf einen Nennstrom IN zur Folge hat (in Fig. 7 gestrichelt dargestellt), der kleiner als der Spitzenstrom IS ist. Diese Reduzierung des Motorstroms IM auf den Nennstrom IN erfolgt durch die Strombegrenzungseinheit 29.

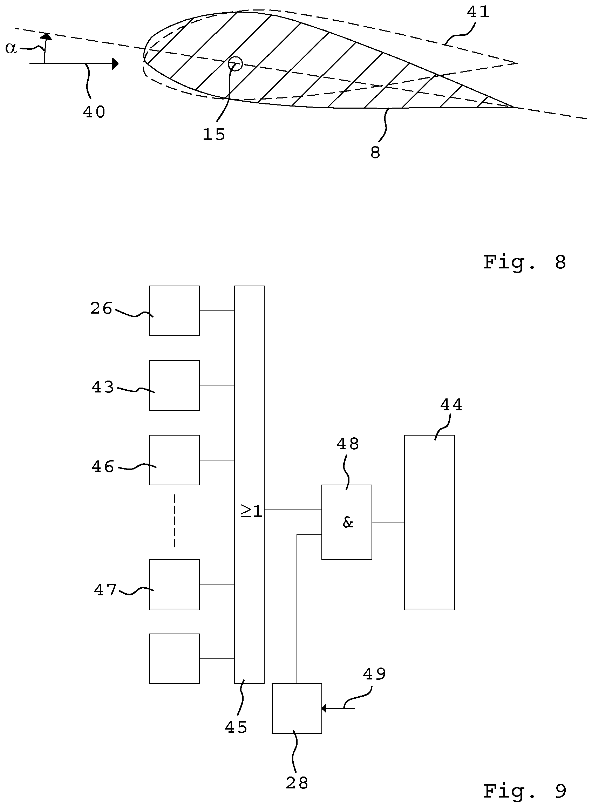

Aus Fig. 8 ist ein schematischer Querschnitt durch das Rotorblatt 8 ersichtlich, wobei α den Anstellwinkel des Rotorblatts 8 zu einer Anströmrichtung 40 der Luft (Wind) bezeichnet. Durch Drehung des Rotorblatts 8 um die Rotorblattachse 15 kann dieses in unterschiedliche Positionen gestellt werden, wobei die gestrichelte Darstellung 41 das in die sichere Position gestellte Rotorblatt 8 veranschaulicht.

Aus Fig. 9 ist eine schematische Darstellung mehrerer Überwachungseinheiten 26, 43, 46, 47 und der Zusatzeinheit 28 ersichtlich, die im aktivierten Zustand eine Unterbrechung des Betriebs des Umrichters 13 durch die Überwachungseinheiten verhindert. Ferner ist eine Unterbrechungsaktivierungseinheit 44 dargestellt, deren Aktivierung eine Unterbrechung des Umrichters 13 herbeiführt. Die für die Aktivierung der Unterbrechungsaktivierungseinheit 44 vorgesehenen Ausgänge der Überwachungseinheiten sind auf die Eingänge einer logischen Verknüpfungseinheit 45 geschaltet, die eine logische ODER-Verknüpfung ihrer Eingänge realisiert und das Ergebnis dieser Verknüpfung als Ausgangssignal abgibt. Zwischen den Ausgang der Verknüpfungseinheit 45 und die Unterbrechungsaktivierungseinheit 44 ist eine logische Verknüpfungseinheit 48 geschaltet, an deren einen Eingang der Ausgang der Verknüpfungseinheit 45 und an deren anderen Eingang die Zusatzeinheit 28 angeschlossen ist. Die Verknüpfungseinheit 48 realisiert eine logische UND-Verknüpfung ihrer beiden Eingänge und liefert das Ergebnis dieser Verknüpfung als Ausgangssignal an die Unterbrechungsaktivierungseinheit 44. Im aktivierten Zustand gibt die Zusatzeinheit 28 stets einen logischen L-Pegel an die Verknüpfungseinheit 48 ab, sodass eine Aktivierung der Unterbrechungsaktivierungseinheit 44 unabhängig vom Ausgangssignal der Überwachungseinheiten unterbunden ist. Die Verknüpfungseinheit 48 gibt in diesem Fall nämlich stets einen logischen L-Pegel an die Unterbrechungsaktivierungseinheit 44 ab, zu deren Aktivierung ein logischer H-Pegel erforderlich ist. Im deaktivierten Zustand gibt die Zusatzeinheit 28 hingegen stets einen logischen H-Pegel an die Verknüpfungseinheit 48 ab, sodass eine Aktivierung der Unterbrechungsaktivierungseinheit 44 durch jede der Überwachungseinheiten möglich ist, indem ein oder mehrere der Überwachungseinheiten als Ausgangssignal einen logischen H-Pegel an die Verknüpfungseinheit 45 abgeben, die dann einen H-Pegel an die Verknüpfungseinheit 48 abgibt. Die Verknüpfungseinheit 48 gibt somit einen logischen H-Pegel an die Unterbrechungsaktivierungseinheit 44 ab, die daraufhin aktiviert wird und eine Unterbrechung des Umrichters 13 herbeiführt. Die Zusatzeinheit 28 kann durch ein Aktivierungssignal 49 aktiviert und deaktiviert werden.

In Fig. 9 sind eine Drehzahlüberwachungseinheit 46 und eine Zwischenkreisspannungsüberwachungseinheit 47 schematisch dargestellt. Die Drehzahlüberwachungseinheit 46 überwacht den Drehzahlistwert nist des Elektromotors 20 und leitet bei Verlust dieses Wertes eine Unterbrechung des Betriebs des Umrichters 13 ein, sofern die Zusatzeinheit 28 deaktiviert ist. Ferner überwacht die Zwischenkreisspannungsüberwachungseinheit 47 die Zwischenkreisspannung UZ und leitet eine Unterbrechung des Betriebs des Umrichters 13 ein, sofern die Zwischenkreisspannung außerhalb eines zulässigen Bereichs liegt und die Zusatzeinheit 28 deaktiviert ist.

Die unter Bezugnahme auf Fig. 9 erläuterte Funktionsweise der Zusatzeinheit 28 und deren Zusammenwirken mit den anderen Einheiten ist lediglich beispielhaft zu verstehen und kann auch anders realisiert werden. Bevorzugt wird die Zusatzeinheit 28 und deren Zusammenwirken mit den anderen Einheiten ganz oder teilweise durch den Rechner 36 numerisch realisiert. Vorzugsweise werden auch die anderen Einheiten ganz oder teilweise durch den Rechner 36 numerisch realisiert.

### Bezugszeichenliste

- 1: Windkraftanlage
- 2: Fundament
- 3: Turm
- 4: Maschinenhaus
- 5: Träger / Halterung
- 6: Rotor
- 7: Rotornabe
- 8: Rotorblatt
- 9: Rotorblatt
- 10: Rotorblatt
- 11: elektrischer Generator
- 12: Blattwinkelverstellsystem
- 13: Umrichter
- 14: Blattwinkelverstellantrieb
- 15: Rotorblattachse
- 16: Rotorblattachse
- 17: Rotorblattachse
- 18: Wind
- 19: Rotorachse
- 20: Elektromotor
- 21: elektrisches Netz, vorzugsweise Wechselstromnetz
- 22: Steuerung
- 23: Gleichrichter
- 24: Zwischenkreiskondensator
- 25: Gleichstromsteller
- 26: Stromüberwachungseinheit
- 27: Strommesser
- 28: Zusatzeinheit
- 29: Strombegrenzungseinheit
- 30: Schaltsignal
- 31: Drehzahlregler
- 32: Drehzahlregelungseinheit
- 33: Drehzahlsensor
- 34: Drehzahlsteuerungseinheit
- 35: Schaltsignal
- 36: Digitalrechner
- 37: Spannungsregler
- 38: Schnittstelle
- 39: externer Eingang des Umrichters
- 40: Anströmrichtung
- 41: sichere Position des Rotorblatts
- 42: Sollwertgeber
- 43: Schnittstellenüberwachungseinheit
- 44: Unterbrechungsaktivierungseinheit
- 45: Verknüpfungseinheit, ODER-Gatter
- 46: Drehzahlüberwachungseinheit
- 47: Zwischenkreisspannungsüberwachungseinheit
- 48: Verknüpfungseinheit, UND-Gatter
- 49: Aktivierungssignal

- IM: Motorstrom
- UB: Belastungssignal
- US: Schwellenwert
- U0: den unbelasteten Zustand kennzeichnendes Signal
- U1: Wert des Belastungssignals zum Schaltzeitpunkt
- UZ: Zwischenkreisspannung
- S1: Schalter
- S2: Schalter
- IS: Spitzenstrom
- IN: Nennstrom
- n: Drehzahl des Motors
- nist: Istdrehzahl
- nsoll: Solldrehzahl
- 10: Startzeitpunkt
- t1: Schaltzeitpunkt
- t2: Zeitpunkt der Überlastung
- α: Anstellwinkel

## Patentansprüche

1. Blattwinkelverstellantrieb für eine Windkraftanlage, mit
- wenigstens einem elektrischen Umrichter (13),
- wenigstens einem mit dem Umrichter (13) elektrisch gekoppelten Elektromotor (20), der durch den Umrichter (12) gespeist wird oder werden kann,
- wenigstens einem mit dem Elektromotor (20) gekoppelten Rotorblatt (8), welches mittels des Elektromotors (20) um eine Rotorblattachse (15) gedreht wird oder werden kann,
- wenigstens einer den Betrieb des Umrichters (13) überwachenden Überwachungseinheit, mittels welcher ein oder mehrere Fehler im Betrieb des Umrichters (13) erkannt und in Abhängigkeit davon der Betrieb des Umrichters (13) zumindest vorübergehend unterbrochen wird oder werden kann,
**gekennzeichnet durch**
- wenigstens eine aktivierbare Zusatzeinheit (28), **durch** deren Aktivierung eine Unterbrechung des Betriebs des Umrichters **durch** die Überwachungseinheit während einer Notausfahrt vermieden wird oder werden kann.

2. Blattwinkelverstellantrieb nach Anspruch 1,
**dadurch gekennzeichnet, dass**
- mittels einer Stromüberwachungseinheit (26) der von dem Umrichter (13) an den Elektromotor (20) abgegebene elektrische Ausgangsstrom (IM) überwacht und in Abhängigkeit davon die Belastung des Umrichters (13) bestimmt wird oder werden kann,
- mittels wenigstens einer Strombegrenzungseinheit (29) in einem überlasteten Zustand des Umrichters (13) der maximal mögliche Ausgangsstrom (IM) auf einen Nennstrom (IN) reduziert wird oder werden kann, der kleiner als ein Spitzenstrom (IS) ist, den der Umrichter (13) in einem nicht überlasteten Zustand als maximal möglichen Ausgangsstrom (IM) zur Verfügung stellt oder stellen kann,
- durch die Aktivierung der Zusatzeinheit (28), unabhängig von der Belastung des Umrichters (13) zum Zeitpunkt der Aktivierung, als maximal möglicher Ausgangsstrom (IM) der Spitzenstrom (IS) während einer Notausfahrt dauerhaft zur Verfügung gestellt wird oder werden kann.

3. Blattwinkelverstellantrieb nach Anspruch 1 oder 2, **dadurch gekennzeichnet, dass**
- mittels einer Drehzahlüberwachungseinheit (46) ein die Drehzahl des Elektromotors (20) repräsentierender Drehzahlistwert (nist) überwacht wird oder werden kann,
- mittels wenigstens eines Drehzahlreglers (31) die Drehzahl (n) des Elektromotors (20) unter Berücksichtigung des Drehzahlistwerts (nist) geregelt wird oder werden kann,
- durch die Aktivierung der Zusatzeinheit (28) der Drehzahlregler (31) bei Verlust des Drehzahlistwerts (nist) in eine steuernde Betriebsart überführt wird oder werden kann, sodass die Drehzahl (n) des Elektromotors (20) während einer Notausfahrt gesteuert wird oder werden kann.

4. Blattwinkelverstellantrieb nach einem der vorangehenden Ansprüche,
**dadurch gekennzeichnet, dass**
bei Durchführung einer Notausfahrt das Rotorblatt (8) um die Rotorblattachse (15) in eine sichere Position gedreht wird oder werden kann.

5. Blattwinkelverstellantrieb nach Anspruch 4,
**dadurch gekennzeichnet, dass**
- mittels einer Schnittstellenüberwachungseinheit (43) eine Schnittstelle (38) des Umrichters (13) überwacht wird oder werden kann, mittels welcher der Umrichter (13) mit einer Steuerung (22) elektrisch verbunden ist,
- bei fehlerhafter Verbindung zwischen dem Umrichter (13) und der Steuerung (22) der Umrichter (13) zur Durchführung einer Notausfahrt angesteuert wird oder werden kann, sodass das Rotorblatt (8) in die sichere Position gedreht wird oder werden kann.

6. Blattwinkelverstellantrieb nach Anspruch 4 oder 5, **dadurch gekennzeichnet, dass**
- der Umrichter (13) einen zwischen einen Gleichrichter (23) und einen Gleichstromsteller oder Wechselrichter (25) geschalteten Zwischenkreis aufweist, an dem eine Zwischenkreisspannung (UZ) anliegt,
- durch die Aktivierung der Zusatzeinheit (28) die Zwischenkreisspannung (UZ) des Umrichters (13) während einer Notausfahrt geregelt wird oder werden kann.

7. Blattwinkelverstellantrieb nach einem der vorangehenden Ansprüche,
**dadurch gekennzeichnet, dass**
die Einheiten ganz oder teilweise durch einen Digitalrechner (36) gebildet sind.

8. Verfahren zum Steuern eines Umrichters eines Blattwinkelverstellantriebs einer Windkraftanlage, wobei
- wenigstens ein mit dem Umrichter (13) elektrisch gekoppelter Elektromotor (20) durch den Umrichter (13) gespeist wird,
- ein Rotorblatt (8) mittels des Elektromotors (20) um eine Rotorblattachse (15) gedreht wird,
- der Betrieb des Umrichters (13) auf Fehler überwacht und im Falle eines Fehlers zumindest vorübergehend unterbrochen wird,
**dadurch gekennzeichnet, dass**
- durch die Aktivierung einer einer Zusatzeinheit (28) eine Unterbrechung des Betriebs des Umrichters (13) im Fehlerfall während einer Notausfahrt vermieden wird.

9. Verfahren nach Anspruch 8,
**dadurch gekennzeichnet, dass**
- der von dem Umrichter (13) an den Elektromotor (20) abgegebene elektrische Ausgangsstrom (IM) überwacht und in Abhängigkeit davon die Belastung des Umrichters (3) bestimmt wird,
- in einem überlasteten Zustand des Umrichters (13) der maximal mögliche Ausgangsstrom (IM) auf einen Nennstrom (IN) reduziert wird, der kleiner als ein Spitzenstrom (IS) ist, den der Umrichter (13) in einem nicht überlasteten Zustand als maximal möglichen Ausgangsstrom (IM) zur Verfügung stellt,
- durch die Aktivierung, unabhängig von der Belastung des Umrichters (13) zum Zeitpunkt der Aktivierung, als maximal möglicher Ausgangsstrom (IM) der Spitzenstrom (IS) während einer Notausfahrt dauerhaft zur Verfügung gestellt wird.

10. Verfahren nach Anspruch 8 oder 9,
**dadurch gekennzeichnet, dass**
- ein die Drehzahl (n) des Elektromotors (20) repräsentierender Drehzahlistwert (nist) überwacht und die Drehzahl (n) des Elektromotors (20) unter Berücksichtigung des Drehzahlistwerts (nist) geregelt wird,
- durch die Aktivierung die Drehzahl (n) des Elektromotors (20) bei Verlust des Drehzahlistwerts (nist) gesteuert wird.

11. Verfahren nach einem der Ansprüche 8 bis 10,
**dadurch gekennzeichnet, dass**
bei einer Notausfahrt das Rotorblatt (8) in eine sichere Position gedreht wird.

12. Verfahren nach Anspruch 11,
**dadurch gekennzeichnet, dass**
- eine elektrische Verbindung (36) zwischen dem Umrichter (13) und einer Steuerung (22) überwacht wird,
- durch die Aktivierung bei einer fehlerhaften Verbindung (36) zwischen dem Umrichter (13) und der Steuerung (22) der Umrichter zur Durchführung einer Notausfahrt angesteuert wird, sodass das Rotorblatt (8) in die sichere Position gedreht wird.

13. Verfahren nach einem der Ansprüche 11 oder 12,
**dadurch gekennzeichnet, dass**
durch die Aktivierung die Zwischenkreisspannung (UZ) des Umrichters (13) während einer Notausfahrt geregelt wird.

## Claims

1. Blade angle adjustment drive for a wind power plant having at least one electrical converter (13), at least one electric motor (20) electrically coupled to the converter (13) which is powered or can be powered by the converter (12), at least one rotor blade (8) coupled to the electric motor (20) which is or can be rotated by means of the electric motor (20) around a rotor blade axis (15), at least one monitoring unit which monitors the operation of the converter (13), which detects one or more malfunctions in the operation of the converter (13), on the basis of which operation of the converter (13) is or can be interrupted at least temporarily,
**characterized by** at least one activatable additional unit (28), the activation of which prevents or can prevent interruption in the operation of the converter by the monitoring unit during an emergency stop operation.

2. Blade angle adjustment drive in accordance with claim 1, **characterized in that** by means of a current monitoring unit (26), the electrical output current (IM) released by the converter (13) to the electric motor (20) is monitored and on this basis, the load of the converter (13) is or can be determined, by means of at least one current monitoring unit (29), when the converter (13) is in an overloaded state, the maximum possible output current (IM) is or can be reduced to a nominal current (IN) which is less than the peak current (IS) which the converter (13) provides or can provide as the maximum possible output current (IM) when in a non-overloaded state,
irrespective of the load of the converter (13) at the time of activation, by activation of the additional unit (28), the peak current (IS) is or can be permanently provided as the maximum possible output current (IM) during an emergency stop operation.

3. Blade angle adjustment drive in accordance with claim 1 or 2, **characterized in that** by means of a speed monitoring unit (46), an actual speed value (nist) representing the speed of the electric motor (20) is or can be monitored, by means of at least one speed controller (31) the speed (n) of the electric motor (20) is or can be controlled taking into account the actual speed value (nist), by activation of the additional unit (28), the speed controller (31) is switched or can be switched to a controlling mode of operation when the actual speed value (nist) is lost, so that the speed (n) of the electric motor (20) during an emergency stop operation is or can be controlled.

4. Blade angle adjustment drive in accordance with one of the preceding claims **characterized in that** on execution of an emergency stop operation, the rotor blade (8) is or can be rotated around the rotor blade axis (15) to a secure position.

5. Blade angle adjustment drive in accordance with claim 4, **characterized in that** an interface monitoring unit (43) monitors or can monitor an interface (38) of the converter (13) which electrically connects the converter (13) to a controller (22), in the event of a defective connection between the converter (13) and the controller (22), the converter (13) is or can be actuated to perform an emergency stop operation such that the rotor blade (8) is or can be rotated to the safe position.

6. Blade angle adjustment drive in accordance with claim 4 or 5, **characterized in that** the converter (13) has an intermediate circuit switched between a rectifier (23) and a direct current chopper or inverter (25) which is supplied with intermediate circuit voltage (UZ), activation of the additional unit (28) regulates or can regulate the intermediate circuit voltage (UZ) of the converter (13) during an emergency stop operation.

7. Blade angle adjustment drive in accordance with one of the preceding claims, **characterized in that** the units are entirely or partially formed by a digital computer (36).

8. Method for controlling a converter of a blade angle adjustment drive of a wind power plant whereby at least one electric motor (20) which is electrically coupled to the converter (13) is supplied by the converter (13), a rotor blade (8) is rotated around the rotor blade axis (15) by the electric motor (20), operation of the converter (13) is monitored for malfunctions, and in the event of a malfunction is interrupted at least temporarily, **characterized in that** the activation of an additional unit (28) prevents operation of the converter (13) being interrupted during an emergency stop operation in the event of a malfunction.

9. Method in accordance with claim 8, **characterized in that** the output current (IM) released by the converter (13) to the electric motor (20) is monitored and on this basis, the load of the converter (3) is determined, when the converter (13) is in an overloaded state, the maximum possible output current (IM) is reduced to a nominal current (IN), which is smaller than a peak current (IS) which the converter (13) provides to the converter as a maximum possible output current (IM) when in an non-overloaded state, irrespective of the load of the converter (13) at the time of activation, activation causes the peak current (IS) to be permanently provided as the maximum possible output current (IM) during an emergency stop operation.

10. Method in accordance with claim 8 or 9, **characterized in that** - an actual speed value (nist) representing the speed (n) of the electric motor (20) is monitored, and the speed (n) of the electric motor (20) is regulated taking into account the actual speed value (nist), by means of activation, the speed (n) of the electric motor (20) is controlled in the event of the actual speed value (nist) being lost.

11. Method in accordance with claims 8 to 10, **characterized in that** in the case of an emergency stop operation, the rotor blade (8) is rotated to a safe position.

12. Method in accordance with claim 11, **characterized in that** an electrical connection (36) between the converter (13) and the controller (22) is monitored, by means of activation, in the event of a defective connection (36) between the converter (13) and the controller (22), the converter is triggered to perform an emergency stop operation such that the rotor blade (8) is rotated to the safe position.

13. Method in accordance with one of the claims 11 or 12, **characterized in that** by means of activation, the intermediate circuit voltage (UZ) of the converter (13) is controlled during an emergency stop operation.

## Revendications

1. Commande de réglage de l'angle des pales pour une éolienne, avec au moins un convertisseur électrique (13), au moins un moteur électrique (20) électriquement accouplé au convertisseur (13), qui est ou peut être alimenté par le convertisseur (12), au moins une pale de rotor (8) accouplée au moteur électrique (20), qui tourne ou peut tourner autour d'un axe de pale de rotor (15) à l'aide du moteur électrique (20), au moins une unité de surveillance surveillant le fonctionnement du convertisseur (13), à l'aide de laquelle un ou plusieurs défauts de fonctionnement du convertisseur (13) sont détectés et à l'aide de laquelle, en fonction de cette détection, le fonctionnement du convertisseur (13) est ou peut être interrompu tout au moins provisoirement, **caractérisée par** au moins une unité complémentaire activable (28), dont l'activation évite ou peut éviter une interruption du fonctionnement du convertisseur par l'unité de surveillance pendant une opération d'arrêt d'urgence.

2. Commande de réglage de l'angle des pales selon revendication 1, **caractérisée en ce que**, à l'aide d'une unité de surveillance du courant (26), le courant de sortie électrique (IM) cédé par le convertisseur (13) au moteur électrique (20) est surveillé et à l'aide de laquelle, en fonction de cette surveillance, la charge du convertisseur (13) est déterminée ou peut être déterminée, à l'aide d'au moins une unité de limitation du courant (29), le courant de sortie maximal possible (IM) est ou peut être ramené, dans un état surchargé du convertisseur (13), à un courant nominal (IN) qui est inférieur à un courant de crête (IS) que le convertisseur (13) met ou peut mettre à disposition, dans un état non surchargé, en tant que courant de sortie maximal possible (IM), par l'activation de l'unité complémentaire (28), indépendamment de la charge du convertisseur (13) au moment de l'activation, le courant de crête (IS) est ou peut être mis durablement à disposition en tant que courant de sortie maximal possible (IM) pendant une opération d'arrêt d'urgence.

3. Commande de réglage de l'angle des pales selon revendication 1 ou 2, **caractérisée en ce que** à l'aide d'une unité de surveillance de la vitesse de rotation (46), une valeur réelle de la vitesse de rotation (nist) représentant la vitesse de rotation du moteur électrique (20) est ou peut être surveillée, à l'aide d'au moins un régulateur de la vitesse de rotation (31), la vitesse de rotation (n) du moteur électrique (20) est ou peut être régulée, en tenant compte de la valeur réelle de la vitesse de rotation (nist), par l'activation de l'unité complémentaire (28), le régulateur de la vitesse de rotation (31) est ou peut être mis dans un mode de commande, en cas de perte de la valeur réelle de la vitesse de rotation (nist), de sorte que la vitesse de rotation (n) du moteur électrique (20) soit ou puisse être commandée pendant une opération d'arrêt d'urgence.

4. Commande de réglage de l'angle des pales selon l'une des revendications précédentes, **caractérisée en ce que**, lors de l'exécution d'une opération d'arrêt d'urgence, la pale de rotor (8) tourne ou peut tourner autour de l'axe de pale de rotor (15) pour se mettre dans une position de sécurité.

5. Commande de réglage de l'angle des pales selon revendication 4, **caractérisée en ce que**, à l'aide d'une unité de surveillance d'interface (43), une interface (38) du convertisseur (13), à l'aide de laquelle le convertisseur (13) est électriquement relié à une commande (22), est ou peut être surveillée, en cas de défaut de raccordement entre le convertisseur (13) et la commande (22), le convertisseur (13) est ou peut être activé pour exécuter une opération d'arrêt d'urgence, de sorte que la pale de rotor (8) tourne ou puisse tourner pour se mettre dans la position de sécurité.

6. Commande de réglage de l'angle des pales selon revendication 4 ou 5, **caractérisée en ce que** le convertisseur (13) présente un circuit intermédiaire monté entre un redresseur (23) et un hacheur ou onduleur (25), au niveau duquel une tension de circuit intermédiaire (UZ) est présente, par l'activation de l'unité complémentaire (28), la tension de circuit intermédiaire (UZ) du convertisseur (13) est ou peut être régulée pendant une opération d'arrêt d'urgence.

7. Commande de réglage de l'angle des pales selon l'une des revendications précédentes, **caractérisée en ce que** les unités sont entièrement ou partiellement constituées par un calculateur numérique (36).

8. Procédé de commande d'un convertisseur d'une commande de réglage de l'angle des pales d'une éolienne, un moteur électrique (20) électriquement accouplé au convertisseur (13), au moins, étant alimenté par le convertisseur (13), une pale de rotor (8) tournant autour d'un axe de pale de rotor (15), à l'aide du moteur électrique (20), le fonctionnement du convertisseur (13) étant soumis à une surveillance des défauts et étant interrompu tout au moins provisoirement en cas de présence d'un défaut, **caractérisé en ce que** par l'activation d'une unité complémentaire (28), une interruption du fonctionnement du convertisseur (13) est évitée, en cas de défaut, pendant une opération d'arrêt d'urgence.

9. Procédé selon revendication 8, **caractérisé en ce que** le courant de sortie électrique (IM) cédé par le convertisseur (13) au moteur électrique (20) est surveillé et que, en fonction de cette surveillance, la charge du convertisseur (3) est déterminée, dans un état surcharge du convertisseur (13), le courant de sortie maximal possible (IM) est ramené à un courant nominal (IN) qui est inférieur à un courant de crête (IS) que le convertisseur (13) met à disposition en tant que courant de sortie maximal possible (IM), dans un état non surchargé, par l'activation, indépendamment de la charge du convertisseur (13) au moment de l'activation, le courant de crête (IS) est mis durablement à disposition en tant que courant de sortie maximal possible (IM) pendant une opération d'arrêt d'urgence.

10. Procédé selon revendication 8 ou 9, **caractérisé en ce que** une valeur réelle de la vitesse de rotation (nist) représentant la vitesse de rotation (n) du moteur électrique (20) est surveillée et que la vitesse de rotation (n) du moteur électrique (20) est régulée, en tenant compte de la valeur réelle de la vitesse de rotation (nist), par l'activation, la vitesse de rotation (n) du moteur électrique (20) est commandée en cas de perte de la valeur réelle de la vitesse de rotation (nist).

11. Procédé selon l'une des revendications 8 à 10, **caractérisé en ce que**, lors d'une opération d'arrêt d'urgence, la pale de rotor (8) tourne pour se mettre dans une position de sécurité.

12. Procédé selon revendication 11, **caractérisé en ce que** un raccordement électrique (36) entre le convertisseur (13) et une commande (22) est surveillé, par l'activation, en cas de défaut de raccordement (36) entre le convertisseur (13) et la commande (22), le convertisseur est activé pour exécuter une opération d'arrêt d'urgence, de sorte que la pale de rotor (8) tourne pour se mettre dans la position de sécurité.

13. Procédé selon l'une des revendications 11 ou 12, **caractérisé en ce que**, par l'activation, la tension de circuit intermédiaire (UZ) du convertisseur (13) est régulée pendant une opération d'arrêt d'urgence.
